# EUROPEAN PATENT SPECIFICATION

(11) **EP 2 328 393 B1**
(45) Date of publication and mention of the grant of the patent: **10.07.2013**
(21) Application number: 10187464.2
(22) Date of filing: 13.10.2010
(51) Int. Cl.: H05K 1/16, H01M 8/02, H05K 1/00, H05K 1/02

(54) **Printed circuit board and fuel cell**
Leiterplatte und Brennstoffzelle
Carte de circuit imprimé et pile à combustible

(30) Priority: 11.11.2009 JP 2009257811
(43) Date of publication of application: 01.06.2011
(73) Proprietor: NITTO DENKO CORPORATION, Ibaraki-shi, Osaka 567-8680 (JP)
(72) Inventor: Hanazono, Hiroyuki, Ibaraki-shi Osaka 567-8680 (JP)
(74) Representative: Gill, Stephen Charles

(56) References cited:
- EP-A1- 1 986 260
- US-A1- 2005 026 028
- US-A1- 2005 202 297
- US-A1- 2006 040 170
- US-A1- 2006 115 703
- US-A1- 2006 141 326
- US-A1- 2008 149 371

## Description

### BACKGROUND OF THE INVENTION

### Field of the Invention

The present invention relates to a printed circuit board and a fuel cell using the same.

### Description of the Background Art

Batteries that are small in size and have high capacity are desired for mobile equipment such as cellular telephones. Therefore, fuel cells capable of providing higher energy density than conventional batteries such as lithium secondary batteries have been developed. Examples of the fuel cells include a direct methanol fuel cell.

In the direct methanol fuel cell, methanol is decomposed by a catalyst, forming hydrogen ions. The hydrogen ions are reacted with oxygen in the air to generate electrical power. In this case, chemical energy can be converted into electrical energy with extremely high efficiency, so that significantly high energy density can be obtained.

A flexible printed circuit board (hereinafter abbreviated as a printed circuit board), for example, is provided as a collector circuit within such a direct methanol fuel cell (JP 2004-200064 A, for example). Part of the printed circuit board is drawn out of the fuel cell. Various external circuits are connected to the part of the printed circuit board that is drawn out of the fuel cell.

In the fuel cell, fuel leakage that may cause power reduction or other problems has to be reliably prevented. In the fuel cell of JP 2004-200064 A, the printed circuit board is fixed in a housing while being sandwiched between gaskets. However, fuel leakage cannot reliably be prevented with the configuration described in JP 2004-200064 A.

US 2005/0026028 proposes a separator for a fuel cell. EP 1986260 proposes a printed circuit board and a fuel cell using the same. US 2008/014937 proposes a flexible circuit formed from a dielectric core sheet and one or more conductive patterned conductive sheets coupled to the dielectric core sheet. US 2006/141326 proposes an integrated current collector and electrical component plate for a fuel cell stack.

### BRIEF SUMMARY OF THE INVENTION

An object of the present invention is to provide a printed circuit board capable of reliably preventing fuel leakage and a fuel cell including the same.
(1) According to the present invention, a printed circuit board to be used in a fuel cell is provided according to claim 1.
   In the printed circuit board, the collector portion is provided on the one surface of the first portion of the insulating layer, and the region for sealing is provided on the one surface of the first portion of the insulating layer to surround the collector portion. The drawn-out conductor portion is provided to overlap the at least part of the collector portion and extend from the region on the other surface of the first portion of the insulating layer to the region on the other surface of the second portion of the insulating layer. The first hole is formed in the position of the insulating layer between the collector portion and the drawn-out conductor portion, and the collector portion and the drawn-out conductor portion are electrically connected to each other through the first hole.
   When the printed circuit board is used in the fuel cell, other members are arranged to be opposite to the one surface of the insulating layer, and a cell element is arranged between the collector portion on the one surface of the insulating layer and the other members. A seal member can be arranged to surround the cell element. The seal member adheres to the region for sealing provided on the first portion of the insulating layer, and adheres to the other members. In the state, a fuel is supplied to the cell element. The second portion of the insulating layer is drawn out of the fuel cell, and an external circuit is connected to the drawn-out conductor portion on the second portion of the insulating layer.
   In this case, since the drawn-out conductor portion is provided on the other surface of the insulating layer, the seal member reliably adheres to the region for sealing of the insulating layer. This suppresses formation of clearance between the seal member and the insulating layer. Accordingly, the fuel is reliably inhibited from leaking out of the seal member. This reliably prevents fuel leakage from the fuel cell and output reduction of the fuel cell.
(2) The first hole may include a plurality of first holes (i.e. the first hole may be one of a plurality of such first holes), the plurality of first holes may be formed in positions of the insulating layer between the collector portion and the drawn-out conductor portion, and the collector portion and the drawn-out conductor portion may be electrically connected to each other through the plurality of first holes.
   In this case, the collector portion and the drawn-out conduction portion are electrically connected to each other through the plurality of first holes, thus improving electrical conductivity between the collector portion and the drawn-out conductor portion. This improves characteristics of the fuel cell using the printed circuit board.
(3) The printed circuit board may further include a terminal conductor portion provided on the one surface of the second portion of the insulating layer to overlap at least part of the drawn-out conductor portion, wherein a second hole may be formed in a position of the insulating layer between the drawn-out conductor portion and the terminal conductor portion, and the terminal conductor portion and the drawn-out conductor portion may be electrically connected to each other through the second hole.
   In this case, the terminal conductor portion electrically connected to the drawn-out conductor portion is provided on the one surface of the insulating layer, thus allowing adhesion between the seal member and the insulating layer to be maintained and allowing an external circuit to be connected to the terminal conductor portion provided on the one surface of the insulating layer.
(4) According to an aspect of the present invention, a printed circuit board to be used in a fuel cell is proveded according to claim 4.
   In each of the first and second boards of the printed circuit board, the collector portion is provided on the one surface of the first portion of the insulating layer, and the region for sealing is provided on the one surface of the first portion of the insulating layer to surround the collector portion. The drawn-out conductor portion is provided to overlap the at least part of the collector portion and extend from the region on the other surface of the first portion of the insulating layer to the region on the other surface of the second portion of the insulating layer. The first hole is formed in the position of the insulating layer between the collector portion and the drawn-out conductor portion, and the collector portion and the drawn-out conductor portion are electrically connected to each other through the first hole. The first portion of the insulating layer of the first board and the first portion of the insulating layer of the second board are integrated while being adjacent to each other with the boundary line interposed therebetween.
   When the printed circuit board is used in the fuel cell, the integrated insulating layer is bent along the boundary line such that the one surface is positioned on the inner side. Then, a cell element is arranged between the collector portion of the first board and the collector portion of the second board. A seal member can be arranged to surround the cell element. The seal member adheres to the region for sealing provided on the first portion of the insulating layer of the first board and the region for sealing provided in the first portion of the insulating layer of the second board. In the state, a fuel is supplied to the cell element. The second portion of the insulating layer of the first board and the second portion of the insulating layer of the second board are drawn out of the fuel cell, and an external circuit is connected to the drawn-out conductor portions on the second portions of the insulating layers.
   In this case, since the drawn-out conductor portions are provided on the other surfaces of the insulating layers, the seal member reliably adheres to the regions for sealing of the insulating layers of the first and second boards. This suppresses formation of clearance between the seal member and the insulating layer of the first board and between the seal member and the insulating layer of the second board. Accordingly, the fuel is reliably inhibited from leaking out of the seal member. This reliably prevents fuel leakage from the fuel cell and output reduction of the fuel cell.
   Either or both of the first and second boards may be a printed circuit board according to the first aspect of the invention. Accordingly, either or both of the first and second boards may have optional features corresponding to any one or any combination of the optional features of the printed circuit board according to the first aspect.
(5) According to another aspect of the present invention, a fuel cell is provided according to claim 5.

In the printed circuit board of the fuel cell, the collector portion is provided on the one surface of the first portion of the insulating layer, and the region for sealing is provided on the one surface of the first portion of the insulating layer to surround the collector portion in each of the first and second boards. The drawn-out conductor portion is provided to overlap the at least part of the collector portion and extend from the region on the other surface of the first portion of the insulating layer to the region on the other surface of the second portion of the insulating layer. The first hole is formed in the position of the insulating layer between the collector portion and the drawn-out conductor portion, and the collector portion and the drawn-out conductor portion are electrically connected to each other through the first hole. The first portion of the insulating layer of the first board and the first portion of the insulating layer of the second board are integrated while being adjacent to each other with the boundary line interposed therebetween.

The printed circuit board is housed in the housing while being bent along the boundary line. The cell element is arranged between the collector portion of the first board and the collector portion of the second board of the bent printed circuit board, and the seal member is arranged to surround the cell element and adhere to the regions for sealing of the first and second boards. The second portion of the insulating layer of the first board and the second portion of the insulating layer of the second board of the printed circuit board are drawn out of the hosing, and an external circuit is connected to the drawn-out conductor portions on the second portions of the insulating layers.

In this case, since the drawn-out conductor portions are provided on the other surfaces of the insulating layers, the seal members reliably adhere to the regions for sealing of the insulating layers of the first and second boards in the first and second boards. This suppresses formation of clearance between the seal member and the insulating layer of the first board and between the seal member and the insulating layer of the second board. Accordingly, the fuel is reliably inhibited from leaking out of the seal member. This reliably prevents fuel leakage from the fuel cell and output reduction of the fuel cell.

According to the present invention, fuel leakage from the fuel cell is reliably prevented. As a result, output reduction of the fuel cell is reliably inhibited.

Other features, elements, characteristics, and advantages of the present invention will become more apparent from the following description of preferred embodiments of the present invention with reference to the attached drawings.

### BRIEF DESCRIPTION OF THE SEVERAL VIEWS OF THE DRAWINGS

Fig. 1 shows a plan view and a sectional view of a printed circuit board according to a first embodiment;
Fig. 2 is a sectional view for illustrating steps in a method of manufacturing the printed circuit board;
Fig. 3 is a sectional view for illustrating steps in the method of manufacturing the printed circuit board;
Fig. 4 shows an external perspective view and a schematic sectional view for illustrating a fuel cell using the printed circuit board;
Fig. 5 shows a plan view and a sectional view showing part of a printed circuit board according to a second embodiment;
Fig. 6 shows a plan view and a sectional view showing part of a printed circuit board according to a third embodiment;
Fig. 7 shows a plan view and a sectional view showing part of a printed circuit board according to a fourth embodiment; and
Fig. 8 shows a plan view and a sectional view showing a printed circuit board according to a fifth embodiment.

### DETAILED DESCRIPTION OF THE INVENTION

Description will be made of a printed circuit board and a fuel cell using the same according to embodiments of the present invention while referring to the drawings. In the embodiments, the printed circuit board refers to a flexible printed circuit board having flexibility.

### (1) First Embodiment

### (1-1) Configuration of Printed Circuit Board

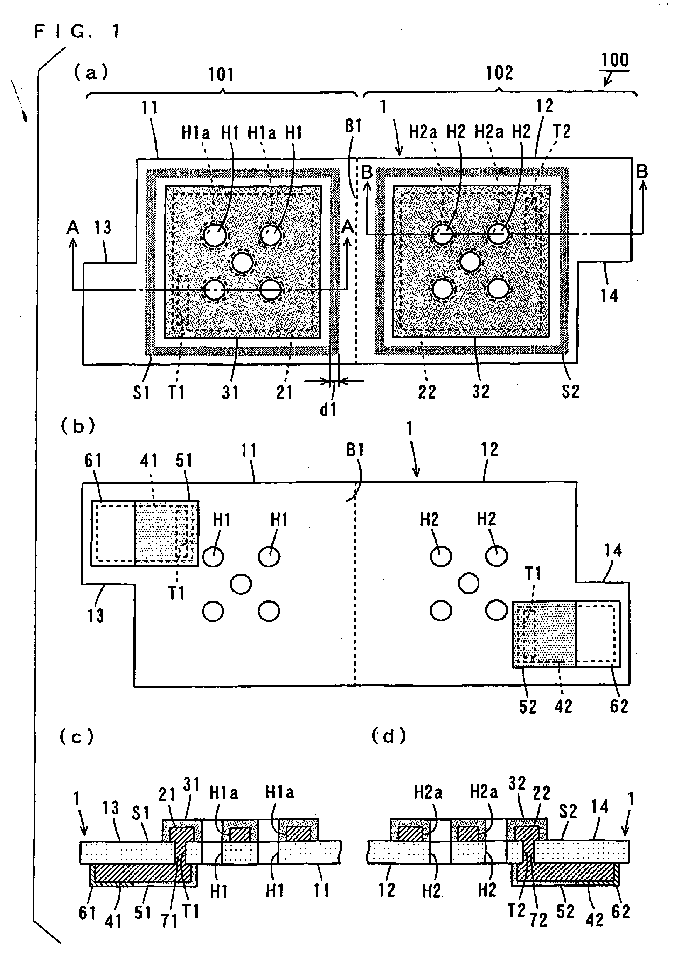

Fig. 1 shows a plan view and a sectional view of a printed circuit board according to a first embodiment. Fig. 1 (a) shows one surface of the printed circuit board, and Fig. 1 (b) shows the other surface of the printed circuit board. Fig. 1 (c) shows a sectional view taken along the line A-A of Fig. 1 (a), and Fig. 1 (d) shows a sectional view taken along the line B-B of Fig. 1 (a).

As shown in Fig. 1 (a), the printed circuit board 100 includes a base insulating layer 1 made of polyimide, for example. The base insulating layer 1 includes a first insulating portion 11, a second insulating portion 12, a third insulating portion 13 and a fourth insulating portion 14 each having a rectangular shape. The first insulating portion 11 and the second insulating portion 12 have the same shape and size, and the third insulating portion 13 and the fourth insulating portion 14 have the same shape and size.

The first insulating portion 11 and the second insulating portion 12 are integrated with each other. A bend portion B1 is provided on a boundary line between the first insulating portion 11 and the second insulating portion 12. The base insulating layer 1 is bent along the bend portion B1 in the fuel cell as described below. The bend portion B1 may be a shallow groove having a line shape or a mark having a line shape, for example. There may be nothing at the bend portion B1 if the base insulating layer 1 can be bent at the bend portion B1.

The third insulating portion 13 is provided to extend outward from a side of the first insulating portion 11 parallel to the bend portion B1, and the fourth insulating portion 14 is provided to extend outward from a side of the second insulating portion 12 parallel to the bend portion B1.

The length of each of the third insulating portion 13 and the fourth insulating portion 14 in a direction parallel to the bend portion B1 is smaller than the length of each of the first insulating portion 11 and the second insulating portion 12 in the direction parallel to the bend portion B1. For example, the length of each of the third insulating portion 13 and the fourth insulating portion 14 in the direction parallel to the bend portion B1 is half the length of each of the first insulating portion 11 and the second insulating portion 12 in the direction parallel to the bend portion B1.

In the present embodiment, the third insulating portion 13 and the fourth insulating portion 14 are provided so as not to overlap each other in a state where the base insulating layer 1 is bent along the bend portion B1. Note that the third insulating portion 13 and the fourth insulating portion 14 may be provided so as to overlap each other in the state where the base insulating layer 1 is bent along the bend portion B1.

A plurality of (five in this example) circular openings H1 are formed in the first insulating portion 11. A plurality of (five in this example) circular openings H2 are formed in the second insulating portion 12.

Rectangular collector portions 21, 22 made of copper, for example, are formed on the first insulating portion 11 and the second insulating portion 12, respectively. Openings H1a each having a larger diameter than the opening H1 are formed in portions of the collector portion 21 overlapping the openings H1 of the first insulating portion 11. Openings H2a each having a larger diameter than the opening H2 are formed in portions of the collector portion 22 overlapping the openings H2 of the second insulating portion 12.

A cover layer 31 is provided on the first insulating portion 11 to cover the collector portion 21, and a cover layer 32 is provided on the second insulating portion 12 to cover the collector portion 22. The cover layers 31, 32 are each made of a resin composition containing carbon (carbon paste, for example).

The cover layer 31 is in contact with the first insulating portion 11 within the openings H1a of the collector portion 21. The cover layer 32 is in contact with the second insulating portion 12 within the openings H2a of the collector portion 22. Therefore, inner peripheral surfaces of the openings H1a, H2a of the collector portions 21, 22 are not exposed.

A seal region S1 is provided on the first insulating portion 11 to surround the cover layer 31. A seal region S2 is provided on the second insulating portion 12 to surround the cover layer 32. A width d1 of each of the seal regions S1, S2 is not less than 0.1 mm and not more than 10 mm, and preferably not less than 0.5 mm and not more than 5 mm, for example.

In the fuel cell, a seal member is arranged to come in contact with the seal region S1 of the first insulating portion 11 and the seal region S2 of the second insulating portion 12 in the state where the base insulating layer 1 is bent along the bend portion B1 as described below. A mark may be put or a shallow groove may be formed in each of the seal regions S1, S2. There may be nothing in the seal regions S1, S2 if the seal member can be arranged to come in contact with the seal regions S1, S2.

Hereinafter, the surface of the base insulating layer 1 on which the collector portions 21, 22 and the cover layers 31, 32 are formed is referred to as a top surface, and the opposite surface is referred to as a back surface.

As shown in Fig. 1 (b), drawn-out conductor portions 41, 42 each having a rectangular shape and made of copper, for example, are formed on the back surface of the base insulating layer 1. The drawn-out conductor portion 41 is provided to extend from a region on the first insulating portion 11 to a region on the third insulating portion 13, and the drawn-out conductor portion 42 is provided to extend from a region on the second insulating portion 12 to a region on the fourth insulating portion 14.

A cover insulating layer 51 made of polyimide, for example, is formed on the back surface of the base insulating layer 1 to cover a portion of the drawn-out conductor portion 41 on the first insulating portion 11, and a cover insulating layer 52 made of polyimide, for example, is formed on the back surface of the base insulating layer 1 to cover a portion of the drawn-out conductor portion 42 on the second insulating portion 12.

A terminal layer 61 made of water-soluble preflux (organic solderability preservative), for example, is formed to cover a portion of the drawn-out conductor portion 41 on the third insulating portion 13, and a terminal layer 62 made of water-soluble preflux, for example, is formed to cover a portion of the drawn-out conductor portion 42 on the fourth insulating portion 14.

As shown in Fig. 1 (c), (d), one end of the drawn-out conductor portion 41 overlaps the collector portion 21 with the first insulating portion 11 sandwiched therebetween. A hole T1 is formed in a portion of the first insulating portion 11 between the collector portion 21 and the drawn-out conductor portion 41. A connecting layer 71 made of copper, for example, is formed to fill the hole T1. This causes the collector portion 21 and the drawn-out conductor portion 41 to be electrically connected to each other.

One end of the drawn-out conductor portion 42 overlaps the collector portion 22 with the second insulating portion 12 sandwiched therebetween. A hole T2 is formed in a portion of the second insulating portion 12 between the collector portion 22 and the drawn-out conductor portion 41. A connecting layer 72 made of copper, for example, is formed to fill the hole T2. This causes the collector portion 22 and the drawn-out conductor portion 42 to be electrically connected to each other.

The length of each of the holes T1, T2 in the direction parallel to the bend portion B1 is not less than 5 µm and not more than 50 µm, and preferably not less than 12. 5 µm and not more than 25 µm, for example.

Afirst board 101 is constituted by the first insulating portion 11, the third insulating portion 13, the collector portion 21, the cover layer 31, the drawn-out conductor portion 41, the cover insulating layer 51, the terminal layer 61 and the connecting layer 71. A second board 102 is constituted by the second insulating portion 12, the fourth insulating portion 14, the collector portion 22, the cover layer 32, the drawn-out conductor portion 42, the cover insulating layer 52, the terminal layer 62 and the connecting layer 72.

While the first board 101 and the second board 102 are integrally formed in the present embodiment, the first board 101 and the second board 102 may be formed separately from each other.

### (1-2) Method of Manufacturing the Printed Circuit Board

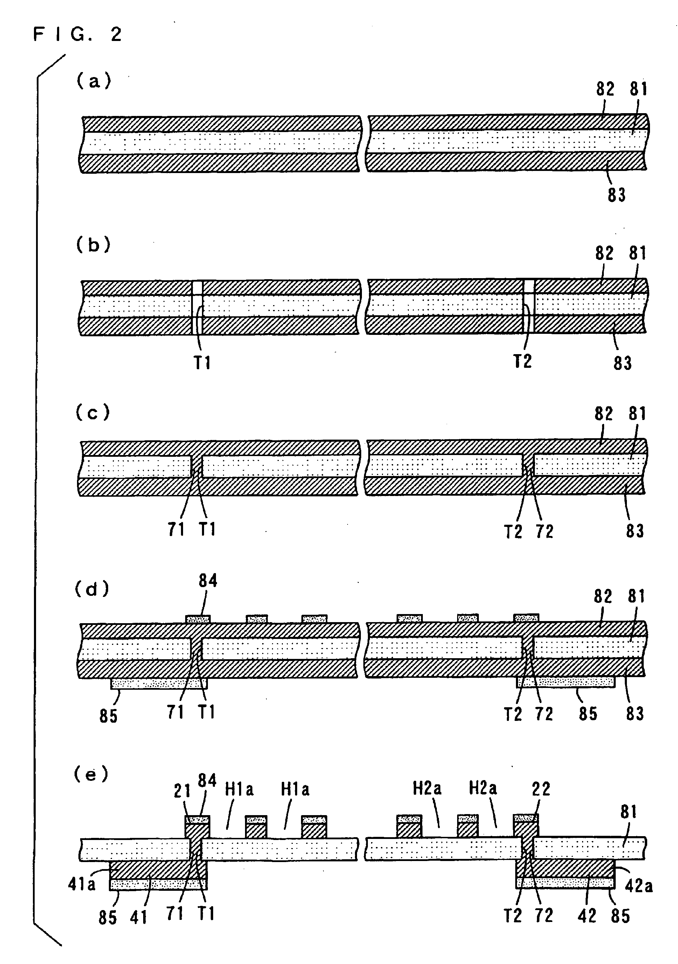

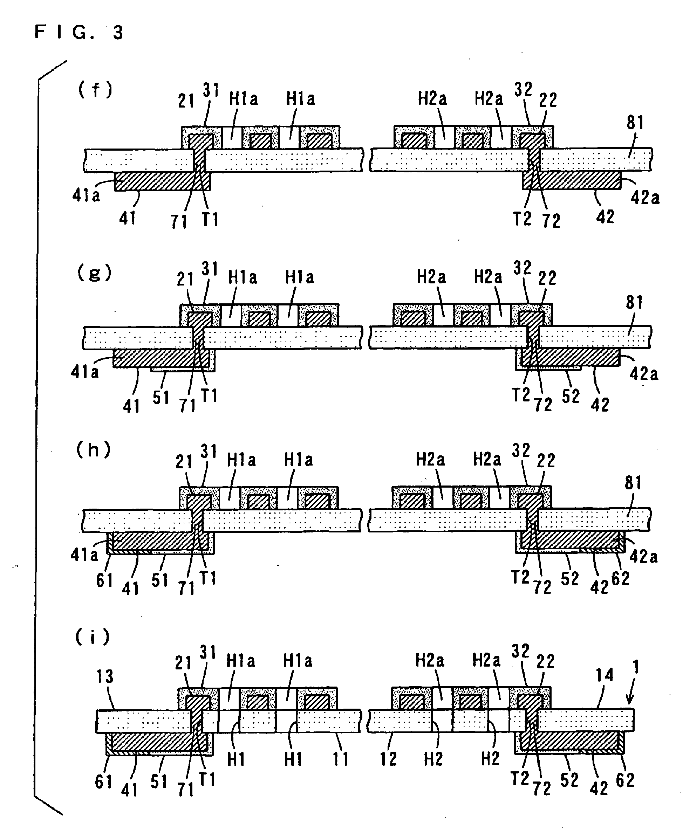

Next, description is made of a method of manufacturing the printed circuit board 100 shown in Fig. 1. Figs. 2 and 3 are sectional views for illustrating steps in the method of manufacturing the printed circuit board 100. Figs. 2 and 3 show manufacturing steps in the portions corresponding to the cross sections shown in Fig. 1 (c), (d).

As shown in Fig. 2 (a), first, a base material composed of an insulating layer 81 made of polyimide, for example, and conductor layers 82, 83 made of copper, for example, formed on one surface and the other surface of the insulating layer 81, respectively, is prepared. The thickness of the insulating layer 81 is not less than 5 µm and not more than 50 µm, and preferably not less than 12.5 µm and not more than 25 µm, for example. The thickness of each of the conductor layers 82, 83 is not less than 2 µm and not more than 70 µm, and preferably not less than 5 µm and not more than 35 µm, for example.

As shown in Fig. 2 (b), the holes T1, T2 are formed to penetrate the insulating layer 81 and the conductor layers 82, 83. Next, the connecting layers 71, 72 made of copper, for example, are formed within the holes T1, T2 of the insulating layer 81 and the conductor layers 82, 83 as shown in Fig. 2 (c).

Then, an etching resist 84 having a given pattern is formed on the conductor layer 82, and an etching resist 85 having a given pattern is formed on the conductor layer 83 (a lower surface of the conductor layer 83 in Fig. 2) as shown in Fig. 2 (d). The etching resists 84, 85 are formed by forming resist films on the conductor layers 82, 83 using a dry film resist or the like, exposing the resist films in the given pattern, and then developing the resist films, for example.

As shown in Fig. 2 (e), regions of the conductor layers 82, 83 excluding regions below the etching resists 84, 85 are subsequently removed by etching. Then, the etching resists 84, 85 are removed by a stripping liquid. Accordingly, the collector portions 21, 22 are formed on one surface (an upper surface in Fig. 2) of the insulating layer 81, and the drawn-out conductor portions 41, 42 are formed on the other surface (a lower surface in Fig. 2) of the insulating layer 81.

Next, the cover layers 31, 32 each made of the resin composition containing carbon are formed on the one surface of the insulating layer 81 to cover the collector portions 21, 22 as shown in Fig. 3 (f). The thickness of each of the cover layers 31, 32 is not less than 0.2 µm and not more than 50 µm, and preferably not less than 5 µm and not more than 30 µm, for example.

Then, the cover insulating layers 51, 52 made of polyimide, for example, are formed on the other surface of the insulating layer 81 to cover the respective one portions of the drawn-out conductor portions 41, 42 as shown in Fig. 3 (g). The thickness of each of the cover insulating layers 51, 52 is not less than 5 µm and not more than 50 µm, and preferably not less than 10 µm and not more than 30 µm, for example.

The terminal layers 61, 62 each made of water-soluble preflux, for example, are subsequently formed to cover the other portions of the drawn-out conductor portions 41, 42 as shown in Fig. 3 (h). The thickness of each of the terminal layers 61, 62 is not less than 0.05 µm and not more than 2 µm, and preferably not less than 0.2 µm and not more than 0.5 µm, for example.

The openings H1, H2 are then formed in the insulating layer 81, and the insulating layer 81 is cut in a given shape as shown in Fig. 3 (i). In this manner, the printed circuit board 100 is completed.

While the collector portions 21, 22 and the drawn-out conductor portions 41, 42 are formed by a subtractive method in Figs. 2 and 3, the present invention is not limited to this. For example, the collector portions 21, 22 and the drawn-out conductor portions 41, 42 may be formed using another method such as a semi-additive method.

### (1-3) The Fuel Cell Using the Printed Circuit Board

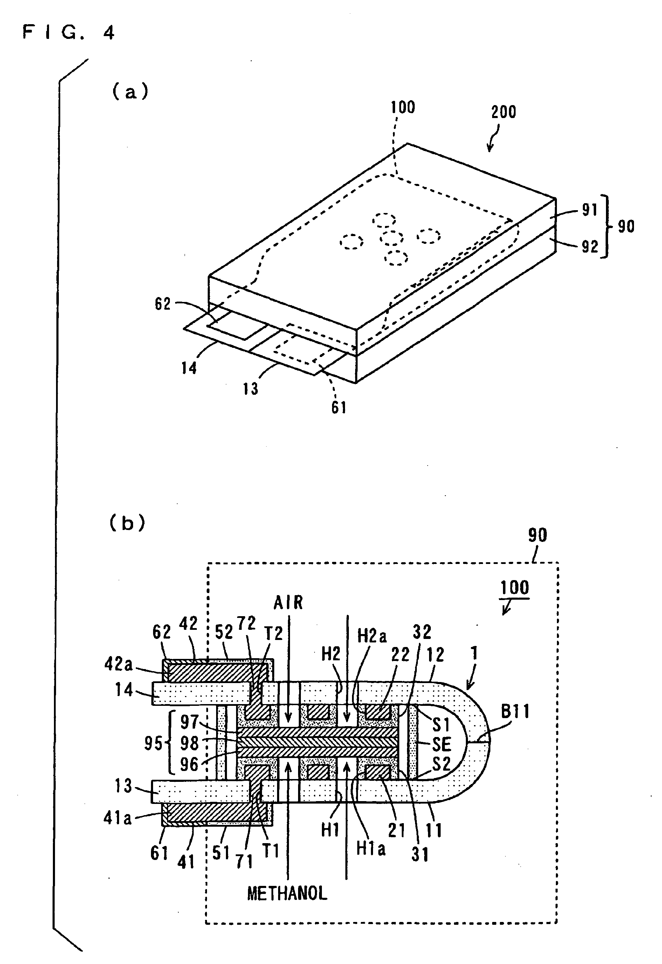

Next, description is made of the fuel cell using the above-described printed circuit board 100. Fig. 4 (a) is an external perspective view of the fuel cell using the printed circuit board 100, and Fig. 4 (b) is a diagram for illustrating actions in the fuel cell.

As shown in Fig. 4 (a), the fuel cell 200 includes a housing 90 having a rectangular parallelepiped shape and composed of half portions 91, 92. The printed circuit board 100 is sandwiched between the half portions 91, 92 in the state where the base insulating layer 1 is bent along the bend portion B1 of Fig. 1 with its top surface (the surface on which the collector portions 21, 22 and the cover layers 31, 32 are formed) positioned on an inner side.

The third insulating portion 13 and the fourth insulating portion 14 of the base insulating layer 1 of the printed circuit board 100 are drawn out from clearance between the half portions 91, 92. In this case, the terminal layer 61 on the drawn-out conductor portion 41 is exposed in a region below the third insulating portion 13, and the terminal layer 62 on the drawn-out conductor portion 42 is exposed in a region above the fourth insulating portion 14 in the outside of the housing 90. Terminals of various external circuits are electrically connected to the terminal layers 61, 62.

As shown in Fig. 4 (b), an electrode film 95 is arranged between the collector portion 21 and the collector portion 22 of the printed circuit board 100. The seal member SE is arranged between the first insulating portion 11 and the second insulating portion 12 of the printed circuit board 100 to surround the electrode film 95. The seal member SE adheres to the seal region S1 of the first insulating portion 11 and the seal region S2 of the second insulating portion 12. This causes a space in the periphery of the electrode film 95 to be sealed by the seal member SE in a liquid-tight manner.

The electrode film 95 is composed of a fuel electrode 96, an air electrode 97 and an electrolyte film 98. The fuel electrode 96 is formed on one surface of the electrolyte film 98, and the air electrode 97 is formed on the other surface of the electrolyte film 98. The fuel electrode 96 of the electrode film 95 is in contact with the cover layer 31 of the printed circuit board 100, and the air electrode 97 is in contact with the cover layer 32 of the printed circuit board 100. The cover layers 31, 32 contain carbon, thus being electrically conductive. Therefore, electrical conductivity between the collector portion 21 and the fuel electrode 96 and between the collector portion 22 and the air electrode 97 is ensured.

A fuel is supplied to the fuel electrode 96 of the electrode film 95 through the openings H1, H1a of the printed circuit board 100. Methanol is employed as the fuel in the present embodiment. Air is supplied to the air electrode 97 of the electrode film 95 through the openings H2, H2a of the printed circuit board 100.

In this case, since the space in the periphery of the electrode film 95 is sealed by the sealing member SE in a liquid-tight manner, the fuel supplied to the electrode film 95 is prevented from leaking out of the seal member SE.

Methanol is decomposed into hydrogen ions and carbon dioxide in the fuel electrode 96, forming electrons. The formed electrons are led from the collector portion 21 to the drawn-out conductor portion 41 of the printed circuit board 100. Hydrogen ions decomposed from methanol pass through the electrolyte film 98 to reach the air electrode 97. In the air electrode 97, hydrogen ions and oxygen are reacted while the electrons led from the drawn-out conductor portion 42 to the collector portion 22 are consumed, thereby forming water. In this manner, electrical power is supplied to the external circuits connected to terminal portions 41a, 42a of the drawn-out conductor portions 41, 42.

### (1-4) Effects

The collector portions 21, 22 are provided on the top surface of the base insulating layer 1, and the drawn-out conductor portions 41, 42 are provided on the back surface of the base insulating layer 1 in the printed circuit board 100 according to the present embodiment.

Here, when the drawn-out conductor portions 41, 42 are provided on the top surface of the base insulating layer 1 integrally with the collector portions 21, 22, the drawn-out conductor portion 41 is arranged to pass through an area between the seal member SE and the first insulating portion 11, and the drawn-out conductor portion 42 is arranged to pass through an area between the seal member SE and the second insulating portion 12.

In this case, adhesion between the seal member SE and the first insulating portion 11 and between the seal member SE and the second insulating portion 12 is reduced to form clearance between the seal member SE and the first insulating portion 11 and between the seal member SE and the second insulating portion 12.

Meanwhile, the drawn-out conductor portions 41, 42 are provided on the back surface of the base insulating layer 1, thereby causing the seal member SE to reliably adhere to the first insulating portion 11 and the second insulating portion 12 in the printed circuit board 100 according to the present embodiment. This suppresses formation of clearance between the seal member SE and the first insulating portion 11 and between the seal member SE and the second insulating portion 12. Accordingly, the fuel supplied to the electrode film 95 is reliably inhibited from leaking out of the seal member SE, resulting in prevention of output reduction of the fuel cell 200.

### (2) Second Embodiment

Description is made of a printed circuit board according to a second embodiment while referring to differences from the above-described first embodiment.

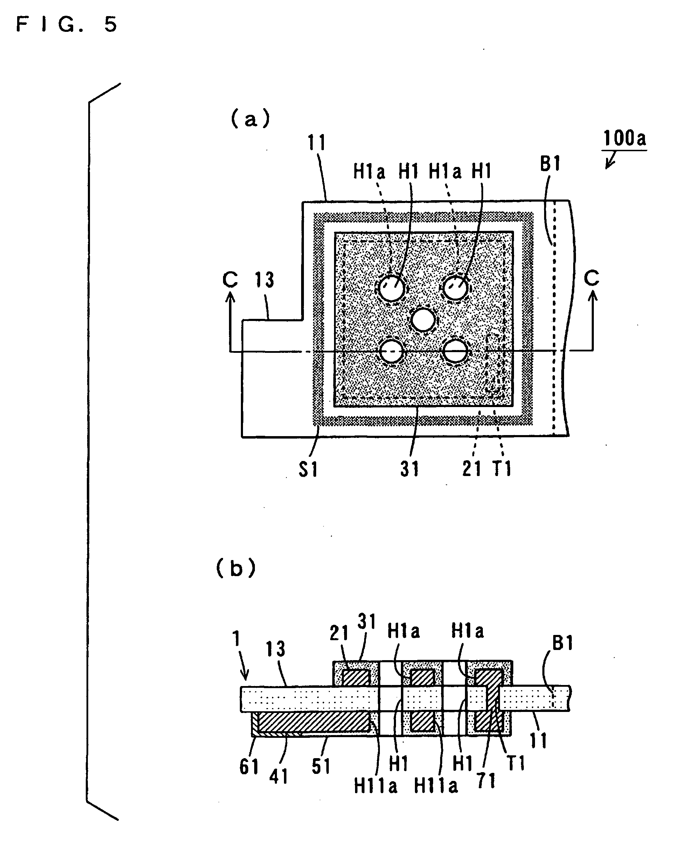

Fig. 5 shows a plan view and a sectional view showing part of the printed circuit board according to the second embodiment. Fig. 5 (a) shows the configurations of the top surfaces of the first insulating portion 11 and the third insulating portion 13, and Fig. 5 (b) shows a cross section taken along the line C-C of Fig. 5 (a). The configurations of the top surfaces and the back surfaces of the second insulating portion 12 and the fourth insulating portion 14 are the same as those of the first insulating portion 11 and the third insulating portion 13 shown in Fig. 5.

As shown in Fig. 5 (a) and (b), the drawn-out conductor portion 41 is formed to extend to a position in proximity to the bend portion B1 in the printed circuit board 100a according to the present embodiment. Openings H11a each having a larger diameter than the opening H1 are formed in portions of the drawn-out conductor portion 41 overlapping the openings H1 of the first insulating portion 11.

The hole T1 and the connecting layer 71 are formed in a portion of the first insulating portion 11 between the collector portion 21 and the drawn-out conductor portion 41 in the vicinity of the bend portion B1.

Also in the printed circuit board 100a according to the present embodiment, the drawn-out conductor portions 41, 42 are provided on the back surface of the base insulating layer 1, thereby causing the seal member SE to reliably adhere to the first insulating portion 11 and the second insulating portion 12 in the fuel cell 200. This suppresses formation of clearance between the seal member SE and the first insulating portion 11 and between the seal member SE and the second insulating portion 12. Accordingly, the fuel supplied to the electrode film 95 is reliably inhibited from leaking out of the seal member SE, resulting in prevention of output reduction of the fuel cell 200.

### (3) Third Embodiment

Description is made of a printed circuit board according to a third embodiment while referring to differences from the above-described second embodiment.

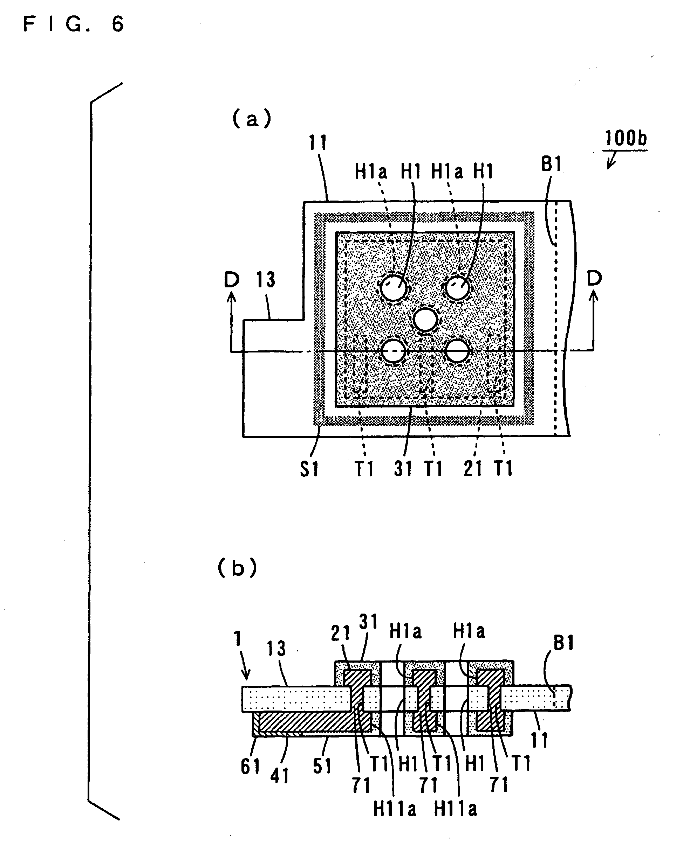

Fig. 6 shows a plan view and a sectional view showing part of the printed circuit board according to the third embodiment. Fig. 6 (a) shows the configurations of the top surfaces of the first insulating portion 11 and the third insulating portion 13, and Fig. 6 (b) shows a cross section taken along the line D-D of Fig. 6 (a). The configurations of the top surfaces and the back surfaces of the second insulating portion 12 and the fourth insulating portion 14 are the same as those of the first insulating portion 11 and the third insulating portion 13 shown in Fig. 6.

As shown in Fig. 6, a plurality of (three in this example) holes T1 and the connecting layers 71 are formed in portions of the first insulating portion 11 between the collector portion 21 and the drawn-out conductor portion 41 in the printed circuit board 100b of the present embodiment.

Also in the printed circuit board 100b of the present embodiment, the drawn-out conductor portions 41, 42 are provided on the back surface of the base insulating layer 1, thereby causing the seal member SE to reliably adhere to the first insulating portion 11 and the second insulating portion 12 in the fuel cell 200. This suppresses formation of clearance between the seal member SE and the first insulating portion 11 and between the seal member SE and the second insulating portion 12. Accordingly, the fuel supplied to the electrode film 95 is reliably inhibited from leaking out of the seal member SE, resulting in prevention of output reduction of the fuel cell 200.

The collector portions 21, 22 are connected to the drawn-out conductor portions 41, 42 through the plurality of connecting layers 71, 72, respectively, thus improving electrical conductivity between the collector portion 21 and the drawn-out conductor portion 41 and between the collector portion 22 and the drawn-out conductor portion 42. This improves the characteristics of the fuel cell 200 using the printed circuit board 100b.

### (4) Fourth Embodiment

Description is made of a printed circuit board according to a fourth embodiment while referring to differences from the above-described first embodiment.

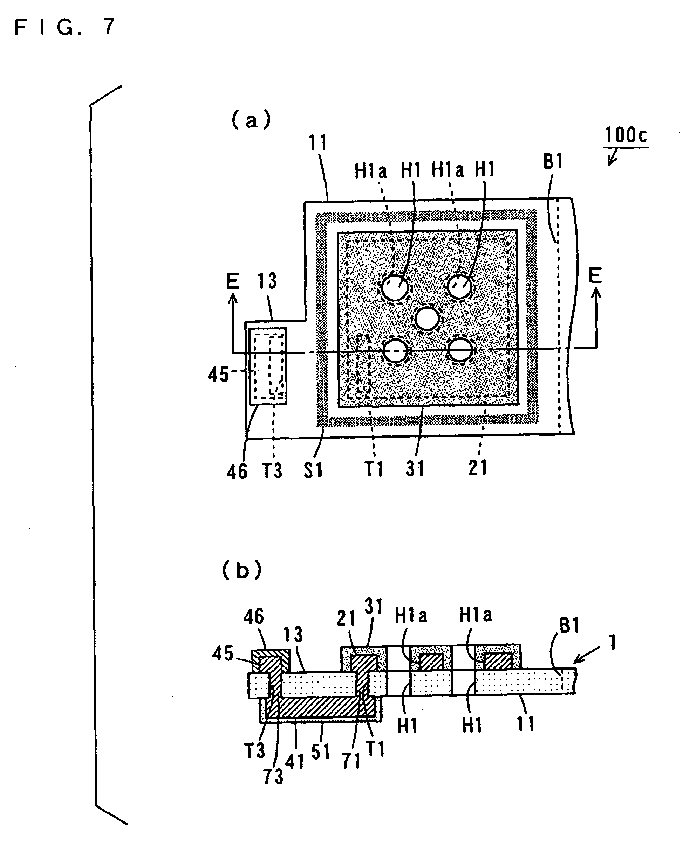

Fig. 7 shows a plan view and a sectional view showing part of the printed circuit board according to the fourth embodiment. Fig. 7 (a) shows the configurations of the top surfaces of the first insulating portion 11 and the third insulating portion 13, and Fig. 7 (b) shows a cross section taken along the line E-E of Fig. 7 (a). The configurations of the top surfaces and the back surfaces of the second insulating portion 12 and the fourth insulating portion 14 are the same as those of the first insulating portion 11 and the third insulating portion 13 shown in Fig. 7.

As shown in Fig. 7, a terminal conductor portion 45 made of copper, for example, is formed on the top surface of the third insulating portion 13 in the printed circuit board 100c of the present embodiment. A terminal layer 46 made of water-soluble preflux, for example, is formed to cover the terminal conductor portion 45.

As shown in Fig. 7 (b), the drawn-out conductor portion 41 is formed on the back surface of the third insulating portion 13 such that its one portion overlaps the terminal conductor portion 45 with the third insulating portion 13 sandwiched therebetween. The cover insulating layer 51 is formed on the back surface of the third insulating portion 13 to cover the entire drawn-out conductor portion 41.

A hole T3 is formed in a portion of the third insulating portion 13 between the terminal conductor portion 45 and the drawn-out conductor portion 41. A connecting layer 73 is formed to fill the hole T3. This causes the collector portion 21, the drawn-out conductor portion 41 and the terminal conductor portion 45 to be electrically connected to one another.

Also in the printed circuit board 100c of the present embodiment, the drawn-out conductor portions 41, 42 are provided on the back surface of the base insulating layer 1, thereby causing the seal member SE to reliably adhere to the first insulating portion 11 and the second insulating portion 12 in the fuel cell 200. This suppresses formation of clearance between the seal member SE and the first insulating portion 11 and between the seal member SE and the second insulating portion 12. Accordingly, the fuel supplied to the electrode film 95 is reliably inhibited from leaking out of the seal member SE, resulting in prevention of output reduction of the fuel cell 200.

### (5) Fifth Embodiment

Description is made of a printed circuit board according to a fifth embodiment while referring to differences from the above-described first embodiment.

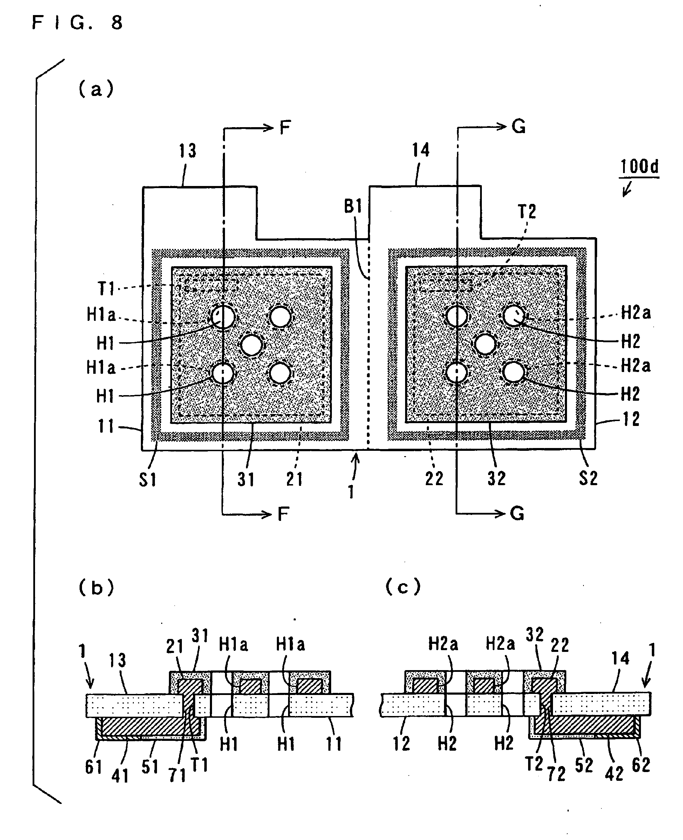

Fig. 8 shows a plan view and a sectional view of the printed circuit board according to the fifth embodiment. Fig. 8 (b) shows a cross section taken along the line F-F of Fig. 8 (a), and Fig. 8 (c) shows a cross section taken along the line G-G of Fig. 8 (a).

As shown in Fig. 8 (a), the third insulating portion 13 and the fourth insulating portion 14 are provided to outwardly extend from sides of the first insulating portion 11 and the second insulating portion 12, respectively, positioned on the common straight line that is perpendicular to the bend portion B1 in the printed circuit board 100d according to the present embodiment.

In the present embodiment, the third insulating portion 13 and the fourth insulating portion 14 are positioned so as not to overlap each other in the state where the base insulating layer 1 is bent along the bend portion B1. Note that the third insulating portion 13 and the fourth insulating portion 14 may be provided so as to overlap each other in the state where the base insulating layer 1 is bent along the bend portion B1.

The cross-sectional configuration of the printed circuit board 100d shown in Fig. 8 (b), (c) is the same as that of the printed circuit board 100 shown in Fig. 1 (c), (d).

Also in the printed circuit board 100d of the present embodiment, the drawn-out conductor portions 41, 42 are provided on the back surface of the base insulating layer 1, thereby causing the seal member SE to reliably adhere to the first insulating portion 11 and the second insulating portion 12 in the fuel cell 200. This suppresses formation of clearance between the seal member SE and the first insulating portion 11 and between the seal member SE and the second insulating portion 12. Accordingly, the fuel supplied to the electrode film 95 is reliably inhibited from leaking out of the seal member SE, resulting in prevention of output reduction of the fuel cell 200.

The openings H1, H2, H1a, H2a are provided in the base insulating layer 1 and the collector portions 21, 22, and the fuel and air are supplied to the electrode film 95 through the openings H1, H2, H1a, H2a in the fuel cell 200 in the foregoing first to fifth embodiments.

### (6) Other Embodiments

Instead of polyimide, another insulating material such as polyethylene terephthalate, polyethylene naphthalate, a liquid crystal polymer or polyphenylene sulfide may be used as a material for the base insulating layer 1. Instead of copper, another metal material such as a copper alloy or aluminum may be used as materials for the collector portions 21, 22, the drawn-out conductor portions 41, 42, the connecting layers 71, 72, 73, and the terminal conductor portion 45.

Instead of the resin composition containing carbon, another electrically conductive material having high corrosion resistance such as an electrically conductive polymer may be used as materials for the cover layers 31, 32. Alternatively, the cover layers 31, 32 may be formed by nickel/gold plating.

Instead of polyimide, another insulating material (for example, NPR-80 manufactured by Nippon Polytech Corp.) may be used as materials for the cover insulating layers 51, 52. Instead of water-soluble preflux, another electrically conductive material having high corrosion resistance may be used as materials for the terminal layers 61, 62, 46. For example, the terminal layers 61, 62, 46 may be formed by nickel/gold plating.

### (7) Correspondences between Elements in the Claims and Parts in Embodiments

In the following paragraph, non-limiting examples of correspondences between various elements recited in the claims below and those described above with respect to various preferred embodiments of the present invention are explained.

In the above-described embodiments, the first board 101 is an example of a first board, the second board 102 is an example of a second board, the base insulating layer 1 is an example of an insulating layer, the first insulating portion 11 or the second insulating portion 12 is an example of a first portion, the third insulating portion 13 or the fourth insulating portion 14 is an example of a second portion, the collector portions 21, 22 are examples of a collector portion, the seal regions S1, S2 are examples of a region for sealing, the seal member SE is an example of a seal member, the drawn-out conductor portions 41, 42 are examples of a drawn-out conductor portion, and the terminal conductor portion 45 is an example of a terminal conductor portion.

As each of various elements recited in the claims, various other elements having configurations or functions described in the claims can be also used.

While preferred embodiments of the present invention have been described above, it is to be understood that variations and modifications will be apparent to those skilled in the art.

## Claims

1. A printed circuit board (100, 100a, 100b, 100c, 100d) to be used in a fuel cell, comprising:
an insulating layer (1) including a first portion (11) and a second portion (13) that extends from said first portion, and having one surface and the other surface;
a collector portion (21) provided on said one surface of said first portion of said insulating layer; and
a drawn-out conductor portion (41) provided to overlap at least part of said collector portion and extend from a region on said other surface of said first portion of said insulating layer to a region on said other surface of said second portion of said insulating layer, wherein
a region for sealing (S1) is provided to surround said collector portion on said one surface of said first portion of said insulating layer, and
a first hole (T1) is formed in a position of said insulating layer between said collector portion and said drawn-out conductor portion, and said collector portion and said drawn-out conductor portion are electrically connected to each other through said first hole; wherein
a plurality of openings (H1) are formed in the first portion of the insulating layer and a plurality of respectively overlapping openings (H1a) are formed in the collector portion for the supply of fuel or air therethrough, **characterized in that**
said printed circuit board further includes a cover layer (31) that is made of a resin composition having electrical conductivity and is provided on said insulating layer to cover said collector portion, and
said cover layer is in contact with said one surface of said insulating layer within said plurality of openings of said collector portion such that inner peripheral surfaces of said plurality of openings of said collector portion are not exposed.

2. The printed circuit board (100b) according to claim 1, wherein said first hole includes a plurality of first holes, said plurality of first holes are formed in positions of said insulating layer between said collector portion and said drawn-out conductor portion, and said collector portion and said drawn-out conductor portion are electrically connected to each other through said plurality of first holes.

3. The printed circuit board (100c) according to claim 1 or 2, further comprising a terminal conductor portion (45) provided on said one surface of said second portion of said insulating layer to overlap at least part of said drawn-out conductor portion, wherein
a second hole (T3) is formed in a position of said insulating layer between said drawn-out conductor portion and said terminal conductor portion, and said terminal conductor portion and said drawn-out conductor portion are electrically connected to each other through said second hole.

4. A printed circuit board (100, 100a, 100b, 100c, 100d) to be used in a fuel cell, comprising a first board (101) and a second board (102), wherein
each of said first and second boards includes a printed circuit board according to claim 1, wherein
said first portion of said insulating layer of said first board and said first portion of said insulating layer of said second board are integrated while being adjacent to each other with a boundary line (B1) interposed between said first portion of said insulating layer of said first board and said first portion of said insulating layer of said second board, and the printed circuit board can be bent along said boundary line such that said one surface is positioned on an inner side.

5. A fuel cell (200) comprising:
a cell element;
a seal member (SE) provided to surround said cell element;
the printed circuit board according to claim 4; and
a housing (90) that houses said printed circuit board, said cell element and said seal member, wherein
said printed circuit board is housed in said housing while being bent along said boundary line, said cell element is arranged between said collector portion of said first board and said collector portion of said second board of said bent printed circuit board, said seal member is arranged to surround said cell element and adhere to said region for sealing of each of said first and second boards, and said second portion of said insulating layer of said first board and said second portion of said insulating layer of said second board are drawn out of said housing.

## Patentansprüche

1. Leiterplatte (100, 100a, 100b, 100c, 100d) zur Verwendung in einer Brennstoffzelle, wobei die Leiterplatte Folgendes umfasst:
eine Isolierungsschicht (1), die einen ersten Abschnitt (11) und einen zweiten Abschnitt (13), der sich von dem ersten Abschnitt weg erstreckt, umfasst und eine Oberfläche sowie eine andere Oberfläche aufweist;
einen Kollektorabschnitt (21), der auf der einen Oberfläche des ersten Abschnitts der Isolierungsschicht bereitgestellt ist, und
einen herausgeführten Leiterabschnitt (41), der bereitgestellt ist, um zumindest einen Teil des Kollektorabschnitts zu überdecken und sich von einem Bereich auf der anderen Oberfläche des ersten Abschnitts der Isolierungsschicht in einen Bereich auf der anderen Oberfläche des zweiten Abschnitts der Isolierungsschicht zu erstrecken, wobei
ein Dichtungsbereich (S1) bereitgestellt ist, um den Kollektorabschnitt auf der einen Oberfläche des ersten Abschnitts der Isolierungsschicht zu umgeben, und
ein erstes Loch (T1) an einer Stelle der Isolierungsschicht zwischen dem Kollektorabschnitt und dem herausgeführten Leiterabschnitt ausgebildet ist und der Kollektorabschnitt und der herausgeführte Leiterabschnitt über das erste Loch elektrisch miteinander verbunden sind; wobei
eine Vielzahl von Öffnungen (H1) in dem ersten Abschnitt der Isolierungsschicht ausgebildet ist und eine Vielzahl entsprechend überlappender Öffnungen (H1a) in dem Kollektorabschnitt zur Zufuhr von Brennstoff oder Luft ausgebildet ist,
**dadurch gekennzeichnet, dass**
die Leiterplatte ferner eine Deckschicht (31) aus einer elektrisch leitfähigen Harzzusammensetzung umfasst, die auf der Isolierungsschicht bereitgestellt ist, um den Kollektorabschnitt abzudecken, und
die Deckschicht mit der einen Oberfläche der Isolierungsschicht in der Vielzahl von Öffnungen des Kollektorabschnitts in Kontakt steht, so dass die Innenumfangsoberflächen der Vielzahl von Öffnungen des Kollektorabschnitts nicht freiliegen.

2. Leiterplatte (100b) nach Anspruch 1, worin das erste Loch eine Vielzahl erster Löcher umfasst, wobei die Vielzahl erster Löcher an Stellen der Isolierungsschicht zwischen dem Kollektorabschnitt und dem herausgeführten Leiterabschnitt ausgebildet ist und der Leiterabschnitt und der herausgeführte Leiterabschnitt über die Vielzahl erster Löcher elektrisch miteinander verbunden sind.

3. Leiterplatte (100c) nach Anspruch 1 oder 2, die ferner einen Anschlussleiterabschnitt (45) umfasst, der auf der einen Oberfläche des zweiten Abschnitts der Isolierungsschicht bereitgestellt ist, um zumindest einen Teil des herausgeführten Leiterabschnitts zu überdecken, wobei
ein zweites Loch (T3) an einer Stelle der Isolierungsschicht zwischen dem herausgeführten Leiterabschnitt und dem Anschlussleiterabschnitt ausgebildet ist und der Anschlussleiterabschnitt und der herausgeführte Leiterabschnitt über das zweite Loch elektrisch miteinander verbunden sind.

4. Leiterplatte (100, 100a, 100b, 100c, 100d) zur Verwendung in einer Brennstoffzelle, die eine erste Platte (101) und eine zweite Platte (102) umfasst, wobei die erste und die zweite Platte jeweils eine Leiterplatte nach Anspruch 1 umfassen, wobei
der erste Abschnitt der Isolierungsschicht der ersten Platte und der erste Abschnitt der Isolierungsschicht der zweiten Platte einstückig ausgebildet sind, wobei sie aneinander angrenzend vorliegen und eine Begrenzungslinie (B1) zwischen dem ersten Abschnitt der Isolierungsschicht der ersten Platte und dem ersten Abschnitt der Isolierungsschicht der zweiten Platte angeordnet ist und die Leiterplatte entlang der Begrenzungslinie so gebogen werden kann, dass sich eine Oberfläche auf einer Innenseite befindet.

5. Brennstoffzelle (200), die Folgendes umfasst:
ein Zellenelement;
ein Dichtungselement (SE), das bereitgestellt ist, um das Zellenelement zu umgeben;
eine Leiterplatte nach Anspruch 4 und
ein Gehäuse (90), das die Leiterplatte, das Zellenelement und das Dichtungselement aufnimmt, wobei
die Leiterplatte in dem Gehäuse aufgenommen ist, wobei sie entlang der Begrenzungslinie gebogen ist, das Zellenelement zwischen dem Kollektorabschnitt der ersten Platte und dem Kollektorabschnitt der zweiten Platte der gebogenen Leiterplatte angeordnet ist, wobei das Dichtungselement angeordnet ist, um das Zellenelement zu umgeben und an dem Dichtungsbereich der ersten und der zweiten Platte anzuhaften, und wobei der zweite Abschnitt der Isolierungsschicht der ersten Platte und der zweite Abschnitt der Isolierungsschicht der zweiten Platte aus dem Gehäuse herausgeführt sind.

## Revendications

1. Carte de circuit imprimé (100, 100a, 100b, 100c, 100d) à utiliser dans une pile à combustible, comprenant :
une couche isolante (1) comprenant une première partie (11) et une deuxième partie (13) qui s'étend de ladite première partie, et ayant une surface et l'autre surface ;
une partie de collecteur (21) prévue sur ladite une surface de ladite première partie de ladite couche isolante ; et
une partie de conducteur sorti (41) prévue de manière à recouvrir au moins une partie de ladite partie de collecteur et s'étendre d'une région sur ladite autre surface de ladite première partie de ladite couche isolante jusqu'à une région sur ladite autre surface de ladite deuxième partie de ladite couche isolante, dans laquelle
une région pour sceller (S1) est prévue de manière à entourer ladite partie de collecteur sur ladite une surface de ladite première partie de ladite couche isolante, et
un premier trou (T1) est formé à une position de ladite couche isolante entre ladite partie de collecteur et ladite partie de conducteur sorti, et ladite partie de collecteur et ladite partie de conducteur sorti sont connectées électriquement l'une à l'autre à travers ledit premier trou ; dans laquelle
une pluralité d'ouvertures (H1) sont formées dans la première partie de la couche isolante et une pluralité d'ouvertures (H1a) respectivement superposées sont formées dans la partie de collecteur pour la fourniture de combustible ou d'air à travers celles-ci, **caractérisée en ce que**
ladite carte de circuit imprimé comprend en outre une couche de recouvrement (31) qui est réalisée en une composition résineuse ayant une conductivité électrique et qui est prévue sur ladite couche isolante de manière à recouvrir ladite partie de collecteur, et
ladite couche de recouvrement est en contact avec ladite une surface de ladite couche isolante dans ladite pluralité d'ouvertures de ladite partie de collecteur de sorte que les surfaces périphériques intérieures de ladite pluralité d'ouvertures de ladite partie de collecteur ne sont pas exposées.

2. Carte de circuit imprimé (100b) selon la revendication 1, dans laquelle ledit premier trou comprend une pluralité de premiers trous, ladite pluralité de premiers trous sont formés à des positions de ladite couche isolante entre ladite partie de collecteur et ladite partie de conducteur sorti, et ladite partie de collecteur et ladite partie de conducteur sorti sont connectées électriquement l'une à l'autre à travers ladite pluralité de premiers trous.

3. Carte de circuit imprimé (100c) selon la revendication 1 ou 2, comprenant en outre une partie de conducteur terminale (45) prévue sur ladite une surface de ladite deuxième partie de ladite couche isolante de manière à recouvrir au moins une partie de ladite partie de conducteur sorti, dans laquelle
un deuxième trou (T3) est formé à une position de ladite couche isolante entre ladite partie de conducteur sorti et ladite partie de conducteur terminale, et ladite partie de conducteur terminale et ladite partie de conducteur sorti sont connectées électriquement l'une à l'autre à travers ledit deuxième trou.

4. Carte de circuit imprimé (100, 100a, 100b, 100c, 100d) à utiliser dans une pile à combustible, comprenant une première carte (101) et une deuxième carte (102), dans laquelle
chacune desdites première et deuxième cartes comprend une carte de circuit imprimé selon la revendication 1, dans laquelle
ladite première partie de ladite couche isolante de ladite première carte et ladite première partie de ladite couche isolante de ladite deuxième carte sont intégrées tout en étant adjacente l'une à l'autre avec une ligne de frontière (B1) interposée entre ladite première partie de ladite couche isolante de ladite première carte et ladite première partie de ladite couche isolante de ladite deuxième carte, et la carte de circuit imprimé peut être pliée le long de ladite ligne de frontière de sorte que ladite une surface soit positionnée d'un côté intérieur.

5. Pile à combustible (200) comprenant :
un élément de pile ;
un élément d'étanchéité (SE) prévu de manière à entourer ledit élément de pile ;
la carte de circuit imprimé selon la revendication 4 ; et
un logement (90) qui reçoit ladite carte de circuit imprimé, ledit élément de pile et ledit élément d'étanchéité, dans laquelle
ladite carte de circuit imprimé est logée dans ledit logement tout en étant pliée le long de ladite ligne de frontière, ledit élément de pile est agencé entre ladite partie de collecteur de ladite première carte et ladite partie de collecteur de ladite deuxième carte de ladite carte de circuit imprimé pliée, ledit élément d'étanchéité est agencé de manière à entourer ledit élément de pile et adhérer à ladite région pour sceller chacune desdites première et deuxième cartes, et ladite deuxième partie de ladite couche isolante de ladite première carte et ladite deuxième partie de ladite couche isolante de ladite deuxième carte sont sorties dudit logement.
